Europäisches Patentamt

(19) European Patent Office

Office européen des brevets

(11) Numéro de publication: **0 223 637 B1**

(12) **FASCICULE DE BREVET EUROPEEN**

(45) Date de publication de fascicule du brevet:
**28.08.91**

(51) Int. Cl.5: **H01L 23/52**, H01L 21/90

(21) Numéro de dépôt: **86402139.9**

(22) Date de dépôt: **01.10.86**

(54) **Procédé de formation d'un réseau métallique multicouche d'interconnexion des composants d'un circuit intégré de haute densité.**

(30) Priorité: **03.10.85 FR 8514669**

(43) Date de publication de la demande:
**27.05.87 Bulletin 87/22**

(45) Mention de la délivrance du brevet:
**28.08.91 Bulletin 91/35**

(84) Etats contractants désignés:
**CH DE FR GB LI NL SE**

(56) Documents cités:
**EP-A- 0 025 261     EP-A- 0 071 010
EP-A- 0 147 203     US-A- 3 506 880
US-A- 3 542 550     US-A- 4 523 975**

(73) Titulaire: **BULL S.A.
121 avenue de Malakoff P.B. 193.16
F-75764 Paris Cédex 16(FR)**

(72) Inventeur: **Merenda, Pierre
32, rue des Orchidées
F 91240 Saint Michel sur Orge(FR)**
Inventeur: **Chantraine, Philippe
27, rue Edmond Bloud
F-92200 Neuilly sur Seine(FR)**
Inventeur: **Lambert, Daniel
54, avenue de la Terrasse
F-91260 Juvisy sur Orge(FR)**

(74) Mandataire: **Denis, Hervé et al
BULL S.A. Industrial Property Department
P.C.: HQ 8M006 P.B. 193.16 121 avenue de
Malakoff
F-75764 Paris Cédex 16(FR)**

EP 0 223 637 B1

## Description

L'invention se rapporte à un procédé de formation d'un réseau métallique multicouche d'interconnexion des composants d'un circuit intégré de haute densité.

Les procédés classiques de formation d'un réseau multicouche d'interconnexion des composants d'une puce consistent essentiellement à former une couche métallique sur une couche diélectrique recouvrant une couche métallique inférieure composée de conducteurs. Actuellement, les couches conductrices sont ordinairement en aluminium et ont une épaisseur de l'ordre du micromètre.

Initialement, la couche métallique inférieure a une épaisseur uniforme et recouvre une surface de base s'étalant au-dessus des composants de la puce. Les conducteurs sont ordinairement gravés en plaçant la couche métallique inférieure sous plasma réactif. Cette gravure est pratiquement anisotrope. Elle s'effectue dans le sens de l'épaisseur de la couche et donne ainsi aux conducteurs une section approximativement rectangulaire. A l'heure actuelle, le pas typique des conducteurs métalliques est de 6 micromètres (6 $\mu$m) pour une largeur de 3 $\mu$m, et il est souhaitable que ces dimensions puissent être abaissées.

La couche gravée est ensuite recouverte d'une couche diélectrique faite ordinairement par un dépôt chimique de dioxyde de silicium minéral (SiO2) en phase vapeur. L'épaisseur typique de cette couche est de l'ordre de 0,8 um. Il es souhaitable que la couche diélectrique ait une épaisseur uniforme sur toute la couche métallique inférieure pour assurer une isolation électrique satisfaisante et uniforme entre les deux couches métalliques.

Ensuite, on procède à la formation d'ouvertures de contact (vias) à travers la couche diélectrique pour l'interconnexion entre les conducteurs et la couche métallique supérieure. Celle-ci est disposée sur la couche diélectrique et dans ses ouvertures, puis elle est gravée pour former des conducteurs de manière analogue à ceux de la couche inférieure. Ce procédé classique est aussi décrit comme tel dans le document EP-A-0 147 203.

Cette technique pose actuellement de graves problèmes, préjudiciables à la densité désirée du réseau d'interconnexion et causés essentiellement par les fronts abrupts des conducteurs de la couche inférieure. En effet, au lieu d'obtenir une couche diélectrique d'épaisseur uniforme, l'expérience montre un retrait du diélectrique dans les angles que font les conducteurs avec leur surface de base dans un plan perpendiculaire aux conducteurs. Plus précisément, comme par exemple décrit dans le document US-A-4 523 975, l'épaisseur de la couche diélectrique diminue progressivement vers le sommet de chaque angle de fond, tangentiellement à une droite correspondant approximativement à la bissectrice de l'angle, appelée ci-après bissectrice par commodité. En elle-même, cette couche présente déjà l'inconvénient d'offrir dans les angles du fond une isolation défectueuse entre les couches métalliques.

Le dépôt de la couche conductrice supérieure sur la couche diélectrique pose en pratique le problème majeur, puisqu'il va évidemment amplifier considérablement les défauts de recouvrement de la couche diélectrique. Effectivement, l'expérience révèle un amincissement très prononcé de la couche conductrice, tangentiellement à la bissectrice des angles du fond. La couche métallique vue dans chaque angle du fond et dans un plan normal aux conducteurs prend ainsi la forme de deux lèvres adjacentes, tangentielles au plan bissecteur de l'angle du fond. L'amincissement présent à la jonction des lèvres crée une résistance électrique indésirable, que la couche accumule dans l'ensemble de ses angles de fond.

Cet inconvénient est encore aggravé lorsque la surface de base des conducteurs inférieurs n'est pas plane et qu'elle recouvre un relief analogue à angles droits. C'est le cas par exemple lorsque la couche conductrice inférieure est métallique et recouvre une autre couche conductrice, en silicium polycristallin ou métallique. Dans ce cas, deux conducteurs peuvent se superposer et créer un vallonnement plus accentué, qui va se répercuter par un amincissement plus étendu et plus accentué de la couche conductrice le long des parois verticales et, par conséquent, par une liaison électrique défectueuse avec la partie adjacente du fond. Dans tous les cas, les conducteurs de la couche supérieure vont ainsi présenter une suite de résistances appréciables dans tous ses angles de fond de poser des problèmes de fiabilité.

La solution actuellement adoptée pour pallier ce grave inconvénient a été de produire des micrograins conducteurs entre les lèvres de la couche conductrice supérieure dans chaque angle du fond. Cependant, il est clair que l'efficacité de ces micrograins est souvent insuffisante. En outre, même si elle s'avérait suffisante, le vallonnement de la couche inférieure soulève un autre problème pour la gravure de la couche conductrice supérieure. La gravure est aussi faite de préférence sous plasma réactif, dont la durée est déterminée par l'épaisseur de la couche à graver. Etant donné que la gravure sous plasma réactif est anisotrope et qu'elle se fait normalement au plan générale de la puce, la durée de la gravure est déterminée par l'épaisseur de la couche conductrice suivant cette direction. Au niveau des fronts raides, il s'avère que l'épaisseur de la couche conductrice suivant cette direction peut atteindre une valeur double de celle des autres parties de la couche qui déterminent le temps de

2

la gravure. La gravure doit donc être poursuivie jusqu'à complète élimination des parties conductrices sur les fronts raides de la couche diélectrique afin d'assurer l'isolation électrique parfaite entre conducteurs voisins. Cependant, la durée supplémentaire de la gravure altère sensiblement sa qualité.

De surcroît, la forme de lèvre que présente la couche diélectrique sur les fronts raides de la couche conductrice inférieure pose un problème particulièrement important et pratiquement insoluble pour la gravure de la couche conductrice supérieure. En effet, le sommet de la lèvre de la couche diélectrique fait écran à la partie métallique placée dans la zone d'ombre du plasma réactif. La gravure s'avère donc imparfaite, laissant des parties résiduelles conductrices aux conséquences facheuses, souvent intolérables (risque de court-circuit).

L'invention résout tous ces problèmes, en rendant la surface de support de la couche métallique supérieure approximativement plane. Un procédé d'aplanissement a déjà été décrit dans le document EP-A-0 071 010. Il consiste essentiellement à étaler, sur la couche diélectrique qui recouvre les conducteurs, une couche de verre visqueux. A cause de la température requise pour rendre le verre visqueux, ce procédé est utilisé avant toute métallurgie et s'applique sur des conducteurs en silicium. Le procédé d'aplanissement de l'invention offre l'avantage de s'appliquer sur des conducteurs métalliques.

Le procédé conforme à l'invention de formation d'un réseau métallique multicouche d'interconnexion des composants d'un circuit intégré de haute densité, consistant à former une couche métallique inférieure incluant des conducteurs à flancs raides, à déposer chimiquement en phase vapeur une couche diélectrique sur la couche métallique inférieure, à ménager des ouvertures dans la couche diélectrique au-dessus des conducteurs, et à recouvrir la couche diélectrique d'une couche métallique supérieure, est caractérisé par les caractéristiques de la revendication 1.

Les caractéristiques et avantages de l'invention ressortiront de la description qui suit, donnée à titre d'exemple et faite en référence aux dessins annexés.

Dans les dessins :
- la figure 1 est une vue en coupe transversale partielle d'un circuit inrégré de haute densité conforme à l'invention ; et
- les figures 2A-2D sont des vues analogues à celle de la figure 1, illustrant les étapes essentielles du procédé conforme à l'invention pour l'obtention du circuit intégré représenté sur la figure 1.

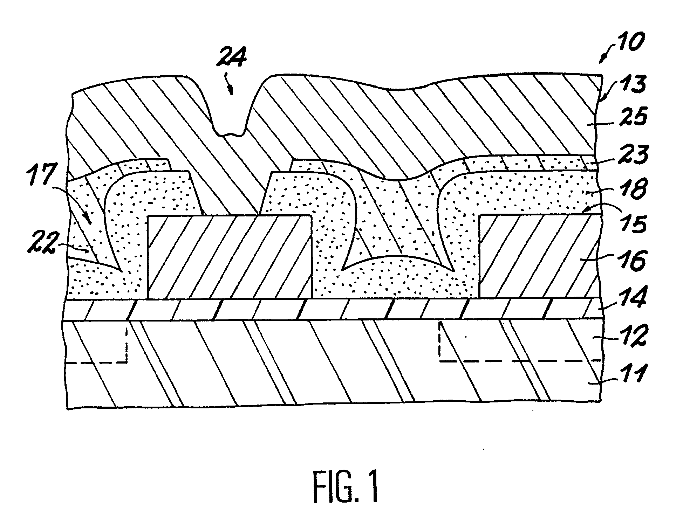

Le circuit intégré de haute densité (10) représente sur la figure 1 se compose d'un substrat semiconducteur (11) incorporant un ensemble de composants (12) illustrés schématiquement, et un réseau métallique (13) pour l'interconnexion de composants (12) du substrat (11). Le réseau (13) a généralement comme surface de base la surface supérieure d'une couche d'isolation (14) recouvrant le substrat (11). Cependant, en technologie MOS (Métal-Oxyde-Semiconducteur), le réseau métallique (13) recouvre souvent une couche primaire de conducteurs d'interconnexion en silicium polycristallin. Etant donné que les conducteurs polycristallins ne posent pas les problèmes résolus par l'invention, ces conducteurs ne sont pas représentés sur la figure 1, mais il est clair qu'un circuit intégré conforme à l'invention peut les incorporer. La description du réseau d'interconnexion (13) du circuit intégré (10) représenté sur figure 1 va maintenant être faite en suivant son procédé de fabrication illustré dans les figures 2A-2D.

En référence aux figures 1 et 2A, le réseau d'interconnexion (13) comprend d'abord, de manière classique, une couche conductrice inférieure (15) couvrant la face supérieure de la couche d'isolation (14). La couche (15) est composée de conducteurs métalliques (16) séparés par des intervalles (17). Les conducteurs (16) sont généralement parallèles entre eux, dans la direction perpendiculaire aux plans des figures illustrées, et présentent une section sensiblement rectangulaire. Cette section est due à la gravure sous plasma réactif d'une couche métallique initiale recouvrant uniformément la couche d'isolation (14). Certaines variantes de cette gravure permettent d'obtenir des fronts moins raides, qui posent néanmoins les mêmes problèmes que ceux à flancs verticaux. L'expression "conducteurs à flancs raides" doit donc être comprise comme englobant les conducteurs dont l'inclinaison des flancs pose les mêmes problèmes que ceux exposés précédemment et illustrés ci-après.

De manière classique également, une couche diélectrique (18) est déposée sur l'ensemble de la couche inférieure (15). Elle est faite ordinairement de dioxyde de silicium minérale déposé chimiquement en phase vapeur. L'expérience révèle qu'un retrait de l'épaisseur de la couche diélectrique (18) se produit dans les angles du fond de la couche (15), c'est-à-dire les angles que forment les conducteurs (16) avec la couche d'isolation (14). Comme illustré, ce retrait donne à la couche un profil de lèvres qui, dans le plan des figures, convergent tangentiellement à une droite (19) correspondant approximativement à la bissectrice de chaque angle. Ce phénomène est dû aux flancs raides des conducteurs et est indépendant de la façon de déposer la couche (18).

La suite du procédé classique consisterait à déposer une couche métallique au-dessus de la couche diélectrique (18). Dans ce cas, le profil de cette couche dans les angles du fond serait celui indiqué par un trait tireté (20) à la figure 2A. On constate que le retrait est nettement accentué par rapport à celui de la couche (18). Le procédé de l'invention remédie à cet inconvénient.

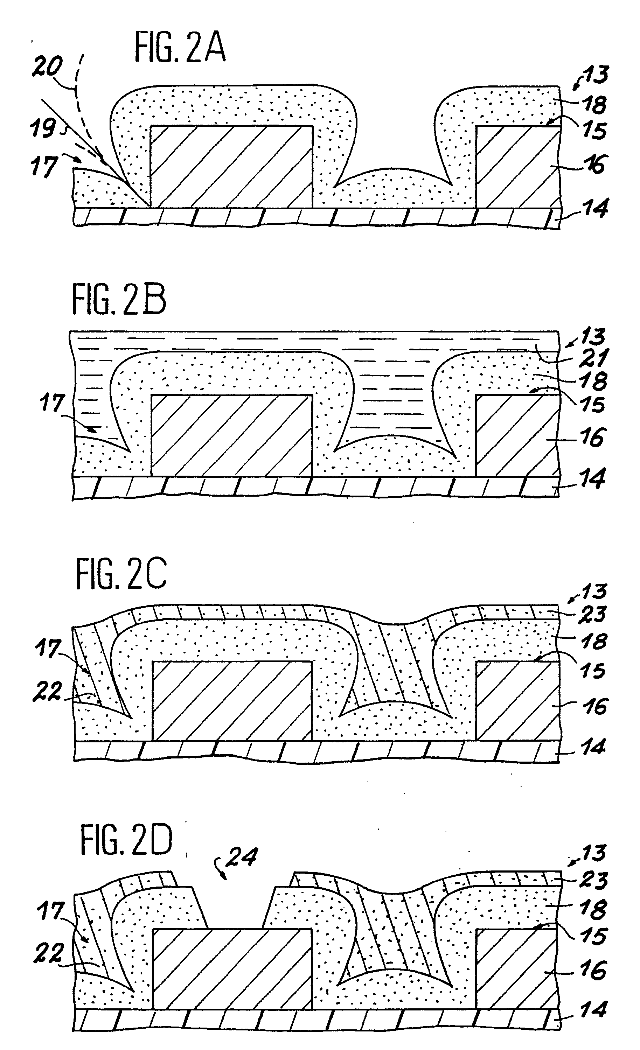

D'une manière générale, l'invention consiste à combler au moins partiellement les creux existant dans les intervalles (17) entre les conducteurs (16), de façon à donner à la couche métallique supérieure une surface de base grossièrement plane. Pour ce faire, une suspension diélectrique visqueuse (21) est déposée sur le circuit intégré (10), puis étalée de manière uniforme sur toute la surface de la couche diélectrique (18). Dans la figure 2B, la suspension (21) a été mise en quantité suffisante pour déborder des creux formés par la couche diélectrique (18) dans les intervalles (17). L'étalement sera de préférence obtenu par la mise en rotation de la tranche semiconductrice (wafer) incluant le circuit intégré (10), à une vitesse déterminée de manière que la force centrifuge vienne en équilibre avec les forces de viscosité de la suspension. Par exemple, la suspension peut être un gel à base de silice minérale, avantageusement sous forme colloïdale, tel que celui appelé couramment S.O.G. (Spin-On-Glass) bien connu dans la technique. Dans ce cas, la suspension diélectrique visqueuse s'utilise de la même manière que les résines photosensibles servant à la configuration des éléments du circuit intégré. En procédant ensuite au recuit de la suspension (21), le solvant de la suspension s'évapore tandis que le diélectrique forme une masse compacte (22) telle que représentée sur la figure 2C. La masse (22) est essentiellement localisée dans les intervalles (17), mais recouvre aussi d'un film mince (23) la couche diélectrique (18) située au-dessus des conducteurs (16). Il est à noter que les films (23) existeront toujours, quel que soit le degré de remplissage des creux dans les intervalles (17), à cause de la viscosité de la suspension (21) et de son étalement. Dans la figure 2D, les ouvertures de contact (24) sont ménagées au-dessus des conducteurs (16) pour leur connexion avec la couche métallique supérieure qui va être déposée ultérieurement. Les ouvertures (24) sont aussi habituellement gravées sous plasma réactif. La gravure normale créerait donc des flancs raides similaires à ceux des conducteurs (16) et produirait le même phénomène de retrait de la couche supérieure dans les angles du fond des ouvertures (24). Pour éviter le retrait, on a recours à une variante classique de la gravure, qui évase les ouvertures et rend aussi les angles du fond très obtus. L'angle d'évasement dépend notamment de la nature du matériau gravé. Par conséquent, à cause de la différence de structure des diélectriques de la masse (21) et de la couche (18), la formation de chaque ouverture (24) aboutit à un profil composé de deux parties troncôniques coaxiales, relatives au film (23) et à la couche (18), la partie relative au film (23) étant plus évasée. Il est à noter que cette variante de gravure sous plasma réactif n'est pas adoptée pour la formation des conducteurs (16), car elle réduirait notablement leur section et s'opposerait au développment des très hautes densités recherchées du réseau d'interconnexion (13).

Le dépôt de la couche métallique supérieure (25) aboutit à la configuration représentée sur la figure 1. Bien entendu, la couche (25) pourra ultérieurement servir de couche inférieure pour la mise en oeuvre du procédé conforme à l'invention de formation d'un réseau d'interconnexion (13) à trois couches métalliques.

## Revendications

1. Procédé de formation d'un réseau métallique multicouche d'interconnexion (13) des composants (12) d'un circuit intégré de haute densité (10), consistant à former une couche métallique inférieure (15) incluant des conducteurs (16) à flancs raides, à déposer chimiquement en phase vapeur une couche diélectrique (18) sur la couche métallique inférieure (15), à ménager des ouvertures (24) dans la couche diélectrique (18) au-dessus des conducteurs (16), et à recouvrir la couche diélectrique (18) d'une couche métallique supérieure (25), caractérisé en ce qu'il consiste à étaler sur la couche diélectrique (18) une suspension diélectrique visqueuse (21), à procéder au recuit de la suspension (21) de façon à évaporer le solvant de la suspension (21) tandis que la suspension (21) forme une masse solide compact (22) comblant approximativement les creux formés par la couche diélectrique (18) dans les intervalles (17) entre les conducteurs (16) et formant au-dessus de chacun des conducteurs (16) un film mince (23), et à ménager les ouvertures (24) dans le film mince (23) et la couche diélectrique (18) correspondante.

2. Procédé selon la revendication 1, caractérisé en ce que la suspension diélectrique (21) est un gel à base de silice, avantageusement sous forme colloïdale.

3. Procédé selon la revendication 1 ou 2, caractérisé en ce que le dépôt chimique en phase vapeur consiste en du dioxyde de silicium.

4. Procédé selon la revendication 1, 2 ou 3, caractérisé en ce que les ouvertures (24) sont gravées sous plasma réactif.

5. Procédé selon la revendication 4, caractérisé en ce qu'on utilise la variante de la gravure sous plasma réactif qui évase les ouvertures (24).

**Claims**

1. A method for forming a multilayered metal network (13) for bonding the components (12) of a high-density integrated circuit (10), comprising forming a lower metal layer (15) including conductors (16) having steep edges, chemically depositing a dielectric layer (18) in the vapour phase onto the lower metal layer (15), forming openings (24) in the dielectric layer (18) over the conductors (16), and covering the dielectric layer (18) with an upper metal layer (25), characterized in that it comprises spreading a viscous dielectric suspension (21) over the dielectric layer (18), proceeding to anneal the suspension (21) so as to evaporate the solvent of the suspension (21) while the suspension (21) forms a compact solid mass (22) approximately filling the hollows formed by the dielectric layer (18) in the intervals (17) between the conductors (16) and forming a thin film (23) over each of the conductors (16), and forming the openings (24) in the thin film (23) and the corresponding dielectric layer (18).

2. A method according to claim 1, characterized in that the dielectric suspension (21) is a silica-based gel, advantageously in colloidal form.

3. A method according to claim 1 or 2, characterized in that the chemical deposit in the vapour phase consists of silicon dioxide.

4. A method according to claim 1,2 or 3, characterized in that the openings (24) are etched in reactive plasma.

5. A method according to claim 4, characterized in that the variant of etching in reactive plasma that flares the openings (24) is used.

**Patentansprüche**

1. Verfahren zur Ausbildung eines metallischen Mehrschichtnetzwerks zur Verbindung (13) von Bauteilen (12) einer integrierten Schaltung (10) mit hoher Dichte, umfassend die Ausbildung einer unteren metallischen Schicht (15), die Leiter (16) mit starren Seitenwänden enthält, die chemische Ablagerung in der Dampfphase einer dielektrischen Schicht (18) auf der unteren metallischen Schicht (15), die Aussparung von Öffnungen (24) in der dielektrischen Schicht (18) oberhalb der Leiter (16) und die Abdeckung der dielektrischen Schicht (18) mit einer oberen metallischen Schicht (25), dadurch gekennzeichnet, daß es die Auftragung einer viskosen, dielektrischen Suspension (21) auf der dielektrischen Schicht (18), die Glühbehandlung der Suspension (21), derart, daß das Lösungsmittel der Suspension (21) verdampft, während die Suspension (21) eine kompakte, feste Masse (22) bildet, die die von der dielektrischen Schicht (18) in den Intervallen (17) zwischen den Leitern (16) gebildeten Vertiefungen annähernd ausfüllt und oberhalb eines jeden Leiters (16) einen dünnen Film (23) bildet, und die Aussparung der Öffnungen (24) im dünnen Film (23) und der entsprechenden dielektrischen Schicht (18) umfaßt.

2. Verfahren gemäß Anspruch 1, dadurch gekennzeichnet, daß die dielektrische Suspension (21) ein Gel auf Kieselerdebasis, vorzugsweise in kolloidaler Form, ist.

3. Verfahren gemaß Anspruch 1 oder 2, dadurch gekennzeichnet, daß die chemische Ablagerung in der Dampfphase Siliziumdioxid umfaßt.

4. Verfahren gemaß Anspruch 1, 2 oder 3, dadurch gekennzeichnet, daß die Öffnungen (4) unter reaktivem Plasma geätzt werden.

5. Verfahren gemäß Anspruch 4, dadurch gekennzeichnet, daß diejenige Variante des Ätzens unter reaktivem Plasma verwendet wird, die die Öffnungen (24) aufweitet.

FIG. 1

# FIG. 2A

# FIG. 2B

# FIG. 2C

# FIG. 2D